# FASCICULE DE BREVET EUROPEEN

(11) **EP 3 690 459 B1**
(45) Date de publication et mention de la délivrance du brevet: **10.05.2023**
(21) Numéro de dépôt: 20154427.7
(22) Date de dépôt: 29.01.2020
(51) Int. Cl.: G01R 31/34, G07C 3/02

(54) **DISPOSITIF AUTONOME DE SUIVI DE TEMPS D'UTILISATION D'UN GROUPE ÉLECTROGÈNE, ET GROUPE ÉLECTROGÈNE ET PROCÉDÉ CORRESPONDANTS**
AUTONOME VORRICHTUNG ZUR ÜBERWACHUNG DER BETRIEBSZEIT EINES STROMGENERATORS, UND ENTSPRECHENDER STROMGENERATOR UND VERFAHREN
STANDALONE DEVICE FOR MONITORING TIME OF USE OF A GENERATOR SET, AND CORRESPONDING GENERATOR SET AND METHOD.

(30) Priorité: 30.01.2019 FR 1900882
(43) Date de publication de la demande: 05.08.2020
(73) Titulaire: SDMO Industries, 29490 Guipavas (FR)
(72) Inventeur: BERGOT, Gilles, 29490 Guipavas (FR)
(74) Mandataire: Vidon Brevets & Stratégie

(56) Documents cités:
- EP-A1- 0 319 422
- WO-A1-2008/009554
- DE-U1- 29 909 200
- FR-A1- 2 635 894
- GB-A- 2 338 848
- US-A1- 2007 209 435
- US-A1- 2015 226 805

## Description

### 1. Domaine de l'invention

Le domaine de l'invention est celui du suivi de l'utilisation et de la maintenance de groupes électrogènes, et notamment des groupes électrogènes portables, destinés notamment à des mises en oeuvre ponctuelles ou temporaires, sur tout type de site et de terrain.

La présente invention trouve donc en particulier des applications dans le domaine des groupes électrogènes portables, et plus généralement des systèmes mobiles comprenant des moyens de production d'électricité, tels que les groupes de soudage ou les mâts d'éclairage. Ces différents systèmes sont englobés par la suite dans le terme « groupe électrogène ».

### 2. Art antérieur

Les groupes électrogènes mobiles ou transportables sont connus depuis de nombreuses années. Ils permettent à des utilisateurs d'avoir un dispositif de fourniture d'électricité d'appoint ou continu, ou pour fournir de l'électricité sur tout type de site ou de terrain non alimenté de manière fixe en électricité (chantier, habitation, port...). Ils peuvent être détenus par des particuliers ou des professionnels, ou mis en location par des sociétés de location de matériels.

Classiquement, un groupe électrogène comprend un châssis sur lequel sont montés notamment un moteur et un alternateur. Le moteur, typiquement un moteur thermique, entraîne en rotation l'alternateur, de façon à produire de l'électricité.

Les groupes électrogènes doivent faire l'objet d'une maintenance régulière, selon des durées de fonctionnement identifiées, déterminées par le fabricant, et par exemple mentionnées dans les notices. Il est utile, en conséquence, de mesurer les durées d'utilisation, ou de fonctionnement, d'un groupe électrogène, pour déterminer les moments où une maintenance est nécessaire.

Il est donc important que l'utilisateur, ou le responsable du parc d'une société de location, connaisse ces durées, et effectue ou fasse effectuer en temps utile les opérations de maintenance requises. Ceci est nécessaire pour garantir le bon fonctionnement du groupe électrogène et sa fiabilité.

Certains groupes, notamment les groupes de forte capacité, sont équipés de moyens de suivi intégrés, mesurant la présence d'un courant ou d'une tension électrique produite par le groupe, et des moyens de calcul des temps de fonctionnement correspondants et de gestion de la maintenance. En revanche, les groupes électrogènes portables ne présentent généralement pas de dispositif de ce type.

En effet, ces dispositifs ne sont pas aisément adaptables sur des groupes électrogènes portables, notamment pour des raisons de compacité et/ou coût de revient, ceux-ci étant commercialisés à des prix relativement faibles.

Les utilisateurs doivent donc estimer par eux-mêmes les temps de fonctionnement et donc les instants de maintenance. Cette absence de suivi autre que manuel est un inconvénient de tels groupes électrogènes portables, puisqu'ils peuvent en conséquence provoquer un entretien ou une maintenance non régulière ou insuffisante, alors que les groupes électrogènes nécessitent, pour leur bon fonctionnement, une maintenance et un entretien réguliers de sorte que, notamment, leurs performances et durabilité ne soient pas altérées.

Un mauvais suivi de l'entretien de ces groupes électrogènes portables, qui peut être également couplé à des défauts de manipulation (chocs, exposition à des températures extrêmes, ...) peut entraîner une détérioration accélérée du groupe électrogène et donc une durée de vie plus faible que prévue ce qui n'est pas satisfaisant.

En outre, en plus de la possibilité d'une détérioration du groupe électrogène, un entretien non régulier, c'est-à-dire non conforme aux recommandations constructeurs, peut engendrer des risques pour les utilisateurs.

Ainsi, il existe un besoin d'amélioration de ces groupes électrogènes portables. Notons, à titre d'exemple seulement, que divers dispositifs de suivi du fonctionnement d'une machine sont connus dans l'état de la technique antérieure. En particulier, référence est faite aux demandes de brevet suivantes: US2007/209435 A1, EP0319422 A1, FR2635894 A1, DE29909200 U1, US2015/226805 A1, WO2008/009554 A1, et GB2338848 A.

### 3. Exposé de l'invention

Un objectif de la présente invention est donc de pallier au moins en partie ces inconvénients de l'art antérieur.

Cet objectif, ainsi que d'autres qui pourront apparaitre dans la suite de la présente description, sont atteints à l'aide d'un dispositif autonome de suivi de temps d'utilisation d'un groupe électrogène, apte à fournir au moins une information caractéristique d'une durée de fonctionnement du groupe électrogène, le dispositif comprenant :
- au moins un premier capteur apte à mesurer un premier paramètre représentatif d'un état de fonctionnement du groupe électrogène ;
- au moins un deuxième capteur apte à mesurer un deuxième paramètre représentatif d'un état de fonctionnement dudit groupe électrogène, lesdits premier et deuxième paramètres étant représentatifs d'aspects distincts du fonctionnement dudit groupe électrogène ;
- des moyens de traitement délivrant ladite information caractéristique d'une durée de fonctionnement, en fonction desdits premier et deuxième paramètres, ledit groupe électrogène étant considéré en fonctionnement par lesdits moyens de traitement lorsque les deux capteurs délivrent des paramètres indiquant un fonctionnement potentiel ;
- des moyens de stockage interne de ladite information caractéristique d'une durée de fonctionnement ;
- des moyens de transmission aptes à transmettre à un terminal ou un serveur externe ladite information caractéristique d'une durée de fonctionnement.

Ainsi, l'invention propose une approche nouvelle et inventive permettant de résoudre au moins en partie les inconvénients de l'art antérieur.

Notamment, un tel dispositif permet à un utilisateur de disposer, sur un outil de suivi externe (par exemple un téléphone, une tablette, un ordinateur, un serveur...) d'un suivi de temps d'utilisation de son ou ses groupes électrogènes, déterminé de façon autonome, c'est-à-dire notamment sans être connecté électriquement au groupe électrogène pour mesurer une tension ou une intensité électrique produite, et en conséquence d'effectuer ou de faire effectuer en temps utile les opérations de maintenance requises.

Le fait de mettre en oeuvre au moins deux capteurs permet de délivrer une information caractéristique d'une durée de fonctionnement de plus grande fiabilité, en évitant notamment de fausses détections de fonctionnement, dans des cas particuliers où un capteur unique détecterait un phénomène similaire à celle qui pourrait être produit par le groupe, mais qui serait en réalité externe. Par exemple, une telle information caractéristique n'est pas perturbée par l'environnement extérieur dans lequel est placé le groupe électrogène (vibrations dues au transport du groupe dans une camionnette, champ électromagnétique dû à une ligne haute tension), et par conséquent les moyens de transmission transmettent l'information caractéristique d'une durée de fonctionnement qui est fiable.

Selon cette approche, le groupe électrogène est considéré en fonctionnement par les moyens de traitement lorsque les deux capteurs mesurent des paramètres indiquant un fonctionnement potentiel, c'est-à-dire lorsque le premier capteur et le deuxième capteur relèvent un paramètre indiquant que le groupe électrogène est en fonctionnement.

En d'autres termes, l'information caractéristique d'un état de fonctionnement n'est délivrée que si les deux capteurs mesurent un paramètre indiquant que le groupe est en fonctionnement.

En outre, l'absence de connectique aux moyens de production d'électricité du groupe permet une intégration sur un groupe électrogène portable simple et peu coûteuse, le cas échéant sous la forme d'un élément optionnel, pouvant être mis en place à tout moment de la vie du groupe électrogène.

Selon un aspect d'au moins un mode de réalisation de l'invention, lesdits premier et deuxième capteurs sont :
- un capteur magnétique apte à relever la présence d'un champ magnétique généré par un alternateur dudit groupe électrogène, et
- un capteur de vibration apte à capter des vibrations générées par un moteur dudit groupe électrogène.

Ces deux informations sont en effet caractéristiques du fonctionnement d'un groupe électrogènes, représentatives d'aspects distincts du fonctionnement et relativement aisées à détecter et analyser.

On comprend que la présence de deux capteurs, l'un magnétique et l'autre de vibration, dans un mode de réalisation particulier, est intéressante, puisqu'elle permet de détecter que les deux éléments majeurs du groupe sont en fonctionnement, l'alternateur et le moteur. Ceci permet également de réduire efficacement le risque de fausse détection.

Il est noté que l'utilisation d'un capteur particulier est connue, pour détecter le fonctionnement d'un groupe électrogène. En revanche, ni le risque de fausse détection due à l'environnement, ni la solution particulière de l'invention, consistant à prendre en compte les données de plusieurs (au moins deux) capteurs pour décider spécifiquement d'un état de fonctionnement n'ont jamais été identifiés. Dans le cas où plusieurs capteurs sont prévus, ceux-ci permettent d'analyser des informations distinctes, par exemple sur l'état d'un composant particulier, mais non spécifiquement de détecter l'état de fonctionnement.

Selon un aspect d'au moins un mode de réalisation de l'invention, ledit premier capteur est un capteur magnétique apte à relever la présence d'un champ électromagnétique compris entre 25 et 450 µT.

Avec cet ordre de grandeur pour les mesures du premier capteur, il est possible de s'affranchir des détections de champs résiduels non caractéristiques d'un état de fonctionnement du groupe électrogène (champ magnétique de l'environnement extérieur par exemple).

Selon un autre aspect d'au moins un mode de réalisation de l'invention, ledit deuxième capteur est un capteur de vibration apte à relever des vibrations comprises entre 20 et 200 Hz.

Selon une caractéristique particulière d'au moins un mode de réalisation, le dispositif comprend des moyens de géolocalisation.

De tels moyens peuvent par exemple permettre de suivre et contrôler la localisation et l'utilisation des groupes, et d'en faciliter la maintenance, notamment dans le cadre de la gestion d'un parc de groupes électrogènes portables (par exemple pour une société de location ou une société possédant plusieurs groupes), et le cas échéant lutter contre le vol ou retrouver un groupe égaré.

Selon un aspect particulier d'au moins un mode de réalisation, les moyens de transmission mettent en oeuvre le protocole de communication Bluetooth^{®} Low Energy.

Ceci permet d'optimiser l'autonomie du dispositif.

Selon encore un autre aspect d'au moins un mode de réalisation de l'invention, le dispositif comprend des moyens d'identification uniques.

Cela peut permettre de faciliter le suivi, et le cas échéant d'identifier le propriétaire du groupe, en cas de vol ou de perte.

L'invention concerne également un groupe électrogène portant ou comprenant un dispositif autonome de suivi de temps d'utilisation selon l'un des modes de réalisation précités.

Selon une caractéristique d'au moins un mode de réalisation de l'invention, le dispositif autonome de suivi de temps d'utilisation est fixé audit châssis par l'intermédiaire de moyens de fixation mécaniques.

Dans ce cas, les moyens de fixation mécanique peuvent être irréversibles, en particulier adaptés pour détecter qu'ils ont été retirés ou déplacés (par exemple pour ne pas faire apparaître toutes les heures d'utilisation).

L'invention concerne également un procédé de suivi de temps d'utilisation d'un groupe électrogène, mettant en oeuvre un dispositif autonome selon l'invention revendiquée, comprenant les étapes suivantes :
- mesure d'un premier paramètre représentatif d'un état de fonctionnement dudit groupe électrogène, à l'aide d'au moins un premier capteur monté dans ledit dispositif autonome ; et
- mesure d'un deuxième paramètre représentatif d'un état de fonctionnement dudit groupe électrogène, à l'aide d'au moins un deuxième capteur monté dans ledit dispositif autonome, lesdits premier et deuxième paramètres étant représentatifs d'aspects distincts du fonctionnement dudit groupe électrogène ;
- traitement, délivrant ladite information caractéristique d'une durée de fonctionnement, en fonction desdits premier et deuxième paramètres, ledit groupe électrogène étant considéré en fonctionnement lorsque les deux capteurs délivrent des paramètres indiquant un fonctionnement potentiel ;
- stockage interne de ladite information caractéristique d'une durée de fonctionnement ;
- transmission à un terminal ou un serveur externe de ladite information caractéristique d'une durée de fonctionnement.

### 4. Liste des figures

D'autres caractéristiques et avantages de l'invention apparaîtront plus clairement à la lecture de la description suivante d'un mode de réalisation particulier, donné à titre de simple exemple illustratif et non limitatif, et des dessins annexés, parmi lesquels :
**[****Fig. 1****]** est une vue en perspective d'un groupe électrogène comprenant un dispositif autonome de suivi du temps d'utilisation selon un mode de réalisation de l'invention ;
**[****Fig. 2****]** est une vue en perspective d'une partie d'un groupe électrogène, sans le cache latéral, comprenant un dispositif autonome de suivi du temps d'utilisation selon le mode de réalisation de la **[****Fig. 1****]** ;
**[****Fig. 3****]** est une vue en perspective de dessous d'un dispositif autonome de suivi du temps d'utilisation fixé au châssis d'un groupe électrogène, selon le mode de réalisation de la **[****Fig. 1****]** ;
**[****Fig. 4****]** est une vue en perspective de dessus d'un dispositif autonome de suivi du temps d'utilisation selon le mode de réalisation de la **[****Fig. 1****]** ;
**[****Fig. 5****]** est une vue en perspective de dessous d'un dispositif autonome de suivi du temps d'utilisation selon le mode de réalisation de la **[****Fig. 1****],** et
**[****Fig. 6****]** est un schéma illustrant différents composants du dispositif autonome de suivi du temps d'utilisation selon le mode de réalisation de la **[****Fig. 1****].**

### 5. Description d'un mode de réalisation

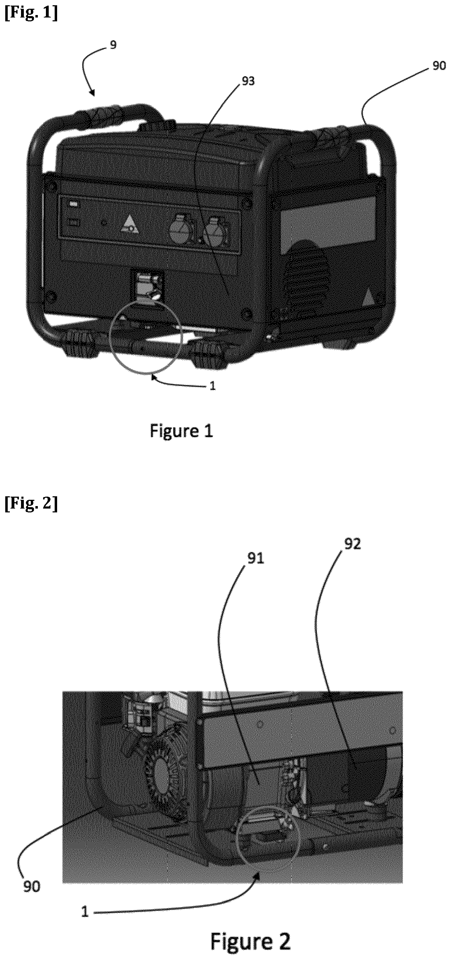

On illustre par la suite un mode de réalisation de l'invention, traité à titre de simple exemple illustratif, et non limitatif, avec l'appui des figures 1 à 6.

Comme illustré sur la figure 1, le groupe électrogène 9 comprend un châssis 90, autrement appelé socle, formant la structure rigide du groupe électrogène, ainsi qu'un capot de protection 93 et un cache latéral protégeant les différents composants.

Sur le châssis 90 et sous le capot 93 sont montés les différents éléments nécessaires à la production d'électricité, et notamment un moteur 91 et un alternateur 92, visibles sur la figure 2.

Comme illustré sur les figures 1 et 2, le groupe électrogène porte en outre un dispositif 1 autonome de suivi de temps d'utilisation du groupe électrogène.

Ce dispositif autonome est placé à proximité du moteur 91 et de l'alternateur de sorte à faciliter le contrôle de ces éléments. Plus particulièrement, une telle proximité permet d'avoir un suivi qui soit relativement précis et fiable, et pour lequel l'environnement extérieur aura un impact minime sur les données recueillies.

Ce dispositif 1 est fixé au moteur 91 par l'intermédiaire de moyens de fixation 13, 20, 21 mécaniques.

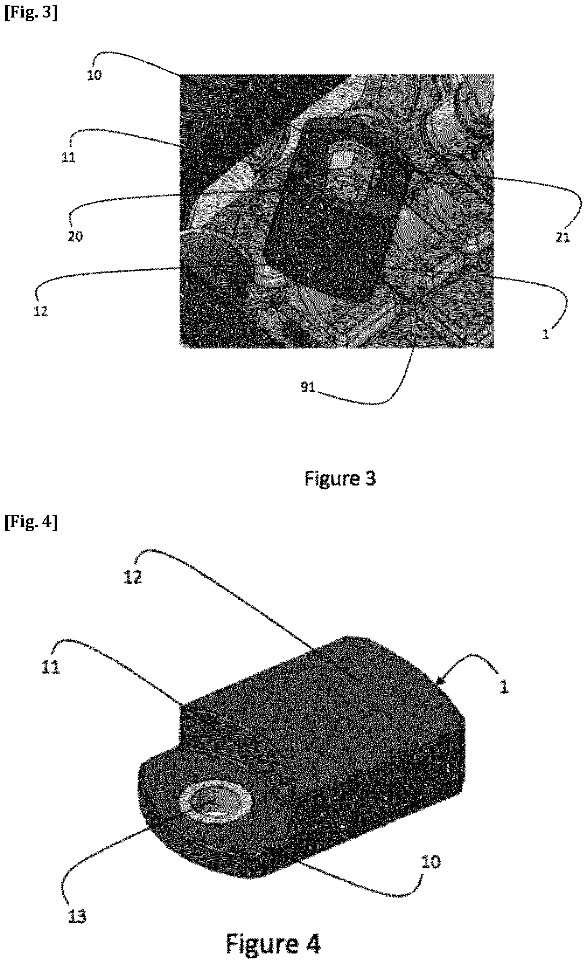

Comme visible sur la figure 3, ces moyens de fixation se présentent sous la forme d'une tige filetée 20 sur laquelle vient se monter le dispositif 1 (à l'endroit d'une lumière 13 illustrée en figure 4), le dispositif autonome étant ensuite maintenu fixe contre le châssis par un écrou 21 qui est ici un écrou hexagonal.

Bien évidemment, dans d'autres modes de réalisation, on pourrait prévoir d'autres moyens de fixations du dispositif au groupe électrogène.

Par exemple, on pourrait prévoir un dispositif fixé au groupe électrogène par des moyens non démontables tel que par soudure.

On pourrait également prévoir un dispositif qui soit moulé ou surmoulé sur un élément du groupe électrogène.

On décrit par la suite un premier mode de réalisation du dispositif 1 autonome de suivi de temps d'utilisation pour groupe électrogène selon l'invention, en relation notamment avec les figures 4 à 6.

Comme illustré sur ces figures, le dispositif 1 comprend une première portion 10 portant la lumière 13. Le pourtour de cette lumière peut porter un anneau de renfort, qui peut par exemple être en métal.

Le dispositif 1 comprend une deuxième portion 12 présentant une épaisseur plus importante que la première portion 10.

Dans ce mode de réalisation, la première portion 10 présente une épaisseur comprise entre 1 mm et 5mm (de l'ordre de 5 mm dans la version illustrée) et la deuxième portion 12 présente une épaisseur comprise entre 10 mm et 20 mm (de l'ordre de 13 mm dans la version illustrée).

Par ailleurs, un tel dispositif 1 autonome peut présenter une longueur (plus grand côté de plusieurs centimètres, préférentiellement inférieure à 20 cm.

En outre, un tel dispositif 1 autonome peut présenter une largueur de plusieurs centimètres, préférentiellement inférieure à 10 cm.

Cette différence d'épaisseur entre la première portion 10 et la deuxième portion 12 forme un rebord 11 délimitant ces première et deuxième portions. Ce rebord peut également former une protection des moyens de fixation du dispositif 1 au groupe électrogène.

La première portion 10 présente, dans ce mode de réalisation, une forme ovale. De son côté, la deuxième portion 12 présente une forme sensiblement rectangulaire. D'autres formes et dimensions sont bien sûr envisageables.

Ce dispositif 1 autonome de suivi du temps d'utilisation pour groupe électrogène 9 est apte à fournir au moins une information caractéristique d'une durée de fonctionnement de ce groupe électrogène.

Une telle information caractéristique de cette durée de fonctionnement peut par exemple comprendre un nombre d'heures de fonctionnement total du groupe électrogène, ou une information sur un nombre d'heures de fonctionnement sans interruption de ce groupe électrogène.

D'autres informations peuvent également être fournies par ce dispositif autonome, tel que des données d'un carnet d'entretien ou de maintenance du groupe électrogène, la date de la première activation, ou la localisation du groupe électrogène.

Le dispositif autonome peut donc, pour se faire, comprendre des moyens de géolocalisation. Ce dernier point peut notamment être utile pour connaître la position d'un groupe, dans le cadre d'une activité de location ou multi-chantier.

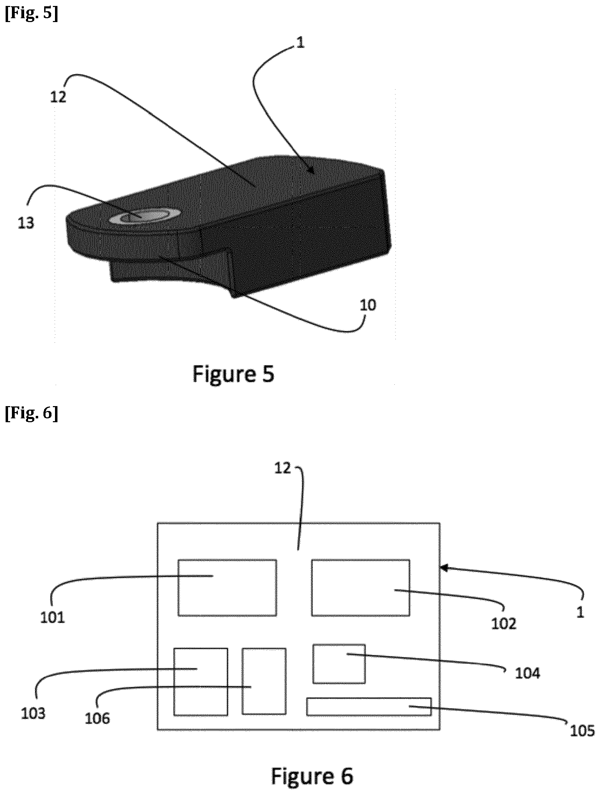

Comme illustré en figure 6, ce dispositif 1 comprend deux capteurs distincts, de façon à valider la détection d'une situation de fonctionnement malgré des environnements éventuellement perturbés :
- un premier capteur 101 apte à mesurer un premier paramètre représentatif d'un état de fonctionnement du groupe électrogène ; et
- un deuxième capteur 102 apte à mesurer un deuxième paramètre représentatif d'un état de fonctionnement du groupe électrogène 9.

Ces deux capteurs sont choisis de façon à détecter des informations différentes, par exemple des signaux électromagnétiques, d'une part, et des signaux représentatifs de vibrations, d'autre part.

Des moyens 104 de traitement reçoivent les signaux des deux (ou plus) capteurs, et les comparent chacun à un seuil prédéterminé, au-delà duquel un fonctionnement potentiel est détecté. Une décision d'état de fonctionnement est déterminée, en fonction d'une combinaison des deux informations de fonctionnement potentiel, par exemple un ET logique. Une information caractéristique d'une durée de fonctionnement est ensuite déterminée, par comptabilisation du temps pendant lequel la décision d'état de fonctionnement est positive.

Par conséquent, l'information caractéristique d'un état de fonctionnement du groupe électrogène 9 délivrée par le dispositif 1 dépend des premier et deuxième paramètres représentatifs mesurés.

Cette information caractéristique d'une durée de fonctionnement est stockée dans des moyens 106 de stockage interne de l'information caractéristique d'une durée de fonctionnement. Elle peut être transmise à un terminal externe ou à un serveur externe, via des moyens de transmission 103

Ce dispositif autonome peut également comprendre une alimentation autonome, non reliée au groupe électrogène, de sorte à être pleinement autonome.

Dans le mode de réalisation illustré, le premier capteur 101 est un capteur magnétique apte à relever la présence d'un champ magnétique généré par l'alternateur 92 du groupe électrogène.

Le paramètre représentatif mesuré par ce premier capteur 101 est donc liée à la rotation de l'alternateur du groupe électrogène ce qui est un paramètre relativement parlant du fait que la différence est importante entre le champ magnétique généré par l'alternateur 92 lorsque celui-ci est en fonctionnement ou non.

En effet, la différence de valeur relevée du champ magnétique généré par l'alternateur est très importante si celui-ci est éteint ou en fonctionnement.

Le fait que le dispositif 1 soit placé à proximité de l'alternateur, comme illustré sur les figures 1 et 2, permet également d'obtenir des relevés fiables de ce premier paramètre représentatif mesuré.

On peut prévoir une analyse affinée du champ magnétique produit, pour en extraire une caractéristique spécifique de l'alternateur (information qui pourrait également être utilisée pour contrôler l'état de l'alternateur et détecter le cas échéant une anomalie).

Pour autant, ceci peut ne pas être suffisant, dans certaines circonstances, par exemple si le groupe est placé à proximité d'une source externe produisant elle-même un champ magnétique (ligne haute tension, par exemple, ou autre groupe à proximité).

Pour pallier ce risque d'erreur, on met en oeuvre un deuxième type de capteur, par exemple un capteur de vibration apte à capter des vibrations générées par le moteur 91 du groupe électrogène 9.

Un tel capteur permet de détecter les vibrations du moteur 91, lorsqu'il est en fonctionnement.

On peut prévoir une analyse affinée des vibrations produites, pour en extraire une caractéristique spécifique du moteur (information qui pourrait également être utilisée pour contrôler l'état du moteur et détecter le cas échéant une anomalie).

En utilisant au moins deux capteurs de types distincts, il est possible de pallier la présence de perturbations. Selon un mode de réalisation particulier, les deux capteurs sont sous la forme d'un capteur de champ magnétique et un capteur de vibration.

De ce fait, l'information caractéristique de la durée de fonctionnement du groupe électrogène 9 fournie par le dispositif 1 tient compte des premier et deuxième paramètres représentatifs mesurés.

Comme déjà explicité, le fait de disposer un premier capteur 101 et deuxième capteur 102 permet de délivrer une information caractéristique d'une durée de fonctionnement qui est plus fiable, et par exemple non perturbé par l'environnement extérieur dans lequel est placé le groupe électrogène, et par conséquent d'émettre une information fiable par les moyens de transmission 103.

En effet, le groupe électrogène est considéré en fonctionnement par lesdits moyens de traitement lorsque les deux capteurs délivrent des paramètres indiquant un fonctionnement potentiel, ici lorsque le moteur et l'alternateur fonctionnent.

Par exemple, dans l'hypothèse où le groupe électrogène est placé dans un environnement présentant un fort champ magnétique, les mesures du premier paramètre représentatif faites par le premier capteur 101 peuvent être perturbées. Toutefois, en recoupant avec les mesures du deuxième paramètre représentatif faites par le deuxième capteur 102 de vibration, le relevé d'un champ magnétique lorsque le groupe électrogène n'est pas en fonctionnement n'est pas identifiée comme un fonctionnement du groupe électrogène car le deuxième capteur ne capte alors pas de vibrations au niveau du moteur 91.

Il en est de même dans l'hypothèse où des vibrations se produisent au niveau du groupe électrogène, par exemple lorsque celui-ci est en cours de transport. Dans cette hypothèse, les mesures du deuxième paramètre représentatif faites par le deuxième capteur 102 peuvent être perturbées du fait des vibrations, dues par exemple aux irrégularités de la route pendant le transport du groupe électrogène. Toutefois, en recoupant avec les mesures du premier paramètre représentatif faites par le premier capteur 101 de champ magnétique, la détection de vibrations lorsque le groupe électrogène n'est pas en fonctionnement n'est pas identifiée comme un fonctionnement du groupe électrogène car le premier capteur ne relève alors pas de champ magnétique au niveau de l'alternateur 92.

Ainsi, à partir de l'analyse de paramètres représentatifs connexes, ici le champ magnétique émis par l'alternateur 92 et les vibrations émises par le moteur 91, le dispositif délivre alors, par l'intermédiaire des moyens de traitement 104, l'information caractéristique d'une durée de fonctionnement du groupe électrogène.

Dans ce mode de réalisation, le premier capteur 101 relève la présence d'un champ électromagnétique compris entre 5 µT et 750 µT, plus particulièrement entre 25 µT et 450 µT.

En outre, le deuxième capteur 102 capte des vibrations comprises entre 20 Hz et 200 Hz. Plus généralement, et selon les modes de réalisation, ce deuxième capteur peut capter des vibrations comprises entre 10 Hz et 1000 Hz.

De ce fait, avec ces ordres de grandeurs pour les mesures du premier capteur 101 et du deuxième capteur 102, on s'affranchit des mesures de grandeurs résiduelles, non caractéristiques d'un état de fonctionnement du groupe électrogène.

Il est à noter que, selon d'autres modes de réalisation, on pourrait prévoir que le premier capteur et le deuxième capteur soient d'autres types.

Par exemple, on pourrait mettre en oeuvre un capteur de température, par exemple de température du moteur.

On pourrait en outre prévoir un capteur de tension aux bornes d'éléments du groupe électrogène.

On pourrait également prévoir un capteur acoustique, par exemple pour évaluer le son émis par le moteur ou par la rotation de l'alternateur.

On pourrait encore prévoir un capteur de pression d'huile, un capteur de vitesse de rotation de l'alternateur, ou un capteur de flux d'air.

On pourrait enfin prévoir des capteurs non autonomes, tel qu'un capteur de valeur analogique de fréquence de l'alternateur, ou un capteur de tension relié à l'alimentation du groupe électrogène.

On pourrait en outre également prévoir un capteur de montage du dispositif autonome sur le châssis de sorte à s'assurer que le dispositif autonome est monté de manière satisfaisante sur le groupe électrogène.

Par ailleurs, on pourrait prévoir des fonctions annexes pour les capteurs mis en oeuvre. On pourrait par exemple prévoir que le capteur de vibration capte aussi un pic de vibration correspondant à un choc sur le groupe électrogène, ceci afin d'émettre une information de risque de détérioration du groupe électrogène.

Les moyens 104 de traitement délivrant l'information caractéristique d'une durée de fonctionnement peuvent comprendre, par exemple, un microcontrôleur, qui reçoit les données en provenance des capteurs et effectue un traitement de ces données. Un tel traitement peut notamment être réalisé en conjonction avec une unité de mesure de base temporelle, cette unité fournissant une mesure d'un temps écoulé.

Les moyens 106 de stockage interne de l'information caractéristique d'une durée de fonctionnement ont pour objectif de réaliser le stockage des données de fonctionnement du dispositif ainsi que, au moins, l'information caractéristique d'une durée de fonctionnement.

Cette unité de stockage peut également être utilisée pour sauvegarder des enregistrements de données comprenant notamment une date, une heure, une localisation et un temps d'utilisation du dispositif. D'autres paramètres peuvent également être enregistrés comme par exemple un temps de mise sous tension, un temps de transport, etc.

L'information caractéristique de la durée de fonctionnement du groupe électrogène peut ensuite être transmise par les moyens de transmission à un terminal externe ou un serveur externe.

Un tel terminal externe peut par exemple être un smartphone d'un utilisateur, ou une tablette.

Les moyens 103 de transmission communiquant l'information peuvent par exemple être basée sur une technologie connue sous le nom Bluetooth « Low Energy ».

Une telle technologie présente l'avantage d'avoir une basse consommation ce qui permet d'avoir une autonomie énergétique relativement importante du dispositif 1, tout en ayant une liaison bidirectionnelle entre le terminal mobile et le dispositif.

Toutefois, on pourrait prévoir d'autres modes de réalisation dans lesquels le mode de communication est unidirectionnel, du dispositif vers le terminal mobile externe ou serveur externe.

On pourrait également prévoir des moyens de communication basés sur une technologie NFC, Zigbee, Bluetooth, Zwave, WiFi, LoRa, Sigfox voire même les réseaux cellulaires mobiles ou les réseaux radio bas-débits. Notamment, le dispositif peut communiquer via des protocoles destinés à « l'internet des objets ».

Dans ce mode de réalisation, et comme illustré sur la figure 6, le dispositif 1 comprend en outre des moyens 105 d'identification de ce dispositif.

Ces moyens d'identifications sont, dans ce mode de réalisation, uniques de sorte à assurer une unicité du dispositif et éviter, par exemple un échange de dispositif entre des groupes électrogènes.

On peut prévoir que de tels moyens d'identification comprennent un numéro de série lié au numéro de série du groupe électrogène.

On peut également prévoir des moyens d'identification du dispositif nécessitant un appairage de ce dispositif autonome avec un terminal mobile, voire avec le groupe électrogène.

Comme indiqué précédemment, on pourrait encore prévoir, selon un mode de réalisation, que le dispositif autonome présente des moyens de géolocalisation.

De cette manière, un éventuel vol de groupe électrogène pourrait être remédié par la détection de la position du groupe électrogène ou du dispositif autonome.

Le dispositif peut également comprendre des indicateurs (diodes électroluminescentes, écran) indiquant un état et/ou signalant un besoin de connexion (si la dernière connexion est trop ancienne), un besoin de maintenance (si la durée enregistrée est supérieure à un seuil)...

L'invention présente notamment l'avantage de permettre à un utilisateur ou un exploitant d'avoir une possibilité de suivi d'une durée de fonctionnement d'un groupe électrogène mobile, voire d'un ensemble de groupes électrogènes mobiles, et de gérer efficacement leur maintenance.

Un autre avantage, selon au moins un mode de réalisation de l'invention, est de fournir une solution qui soit fiable quelque soit le contexte d'utilisation du groupe électrogène.

Un autre avantage d'au moins un mode de réalisation de l'invention est de mettre en oeuvre un dispositif qui est simple d'utilisation et peu coûteux à implémenter.

On peut également noter que l'installation du dispositif peut être faite lors de la fabrication du groupe ou plus tard, sous la forme d'une option ou d'un complément.

## Revendications

1. Dispositif (1) autonome de suivi de temps d'utilisation d'un groupe électrogène (9), apte à fournir au moins une information caractéristique d'une durée de fonctionnement dudit groupe électrogène (9), ledit dispositif (1) comprenant :
- au moins un premier capteur (101) apte à mesurer un premier paramètre représentatif d'un état de fonctionnement dudit groupe électrogène (9) ; et
- au moins un deuxième capteur (102) apte à mesurer un deuxième paramètre représentatif d'un état de fonctionnement dudit groupe électrogène (9), lesdits premier et deuxième paramètres étant représentatifs d'aspects distincts du fonctionnement dudit groupe électrogène (9) ;
- des moyens (104) de traitement délivrant ladite information caractéristique d'une durée de fonctionnement, en fonction desdits premier et deuxième paramètres, ledit groupe électrogène (9) étant considéré en fonctionnement lorsque les deux capteurs (101, 102) délivrent des paramètres indiquant un fonctionnement potentiel ;
- des moyens (106) de stockage interne de ladite information caractéristique d'une durée de fonctionnement ;
- des moyens (103) de transmission aptes à transmettre à un terminal ou un serveur externe ladite information caractéristique d'une durée de fonctionnement.

2. Dispositif (1) autonome de suivi de temps d'utilisation selon la revendication 1, **caractérisé en ce que** lesdits premier et deuxième capteurs (101,102) sont des capteurs sans contact avec ledit groupe électrogène (9).

3. Dispositif (1) autonome de suivi de temps d'utilisation selon la revendication 1, **caractérisé en ce que** lesdits premier et deuxième capteurs (101, 102) sont :
- un capteur magnétique (101) apte à relever la présence d'un champ magnétique généré par un alternateur (92) dudit groupe électrogène (9) ; et
- un capteur de vibration (102) apte à capter des vibrations générées par un moteur (91) dudit groupe électrogène (9).

4. Dispositif (1) autonome de suivi de temps d'utilisation selon la revendication 3, **caractérisé en ce que** ledit premier capteur (101) est un capteur magnétique relevant la présence d'un champ électromagnétique compris entre 25 et 450 µT.

5. Dispositif (1) autonome de suivi de temps d'utilisation selon l'une des revendications 3 ou 4, **caractérisé en ce que** ledit deuxième capteur (102) est un capteur de vibration captant des vibrations comprises entre 20 et 200 Hz.

6. Dispositif (1) autonome de suivi de temps d'utilisation selon l'une des revendications 1 à 5, **caractérisé en ce qu'**il comprend des moyens de géolocalisation.

7. Dispositif (1) autonome de suivi de temps d'utilisation selon l'une des revendications précédentes, **caractérisé en ce que** les moyens (103) de transmission mettent en oeuvre un protocole de communication Bluetooth Low Energy.

8. Dispositif (1) autonome de suivi de temps d'utilisation selon l'une des revendications précédentes, **caractérisé en ce qu'**il comprend des moyens (105) d'identification uniques.

9. Groupe électrogène (9) comprenant un châssis (90) sur lequel sont montés notamment un moteur (91) et un alternateur (92), **caractérisé en ce qu'**il comprend en outre un dispositif (1) autonome de suivi de temps d'utilisation selon l'une des revendications 1 à 8.

10. Groupe électrogène (9) selon la revendication précédente, **caractérisé en ce que** ledit dispositif (1) autonome de suivi de temps d'utilisation est fixé audit châssis (90) par l'intermédiaire de moyens de fixation (13, 20, 21) mécaniques.

11. Procédé de suivi de temps d'utilisation d'un groupe électrogène (9), mettant en œuvre un dispositif (1) autonome selon l'une des revendications 1 à 8, comprenant les étapes suivantes :
- mesure d'un premier paramètre représentatif d'un état de fonctionnement dudit groupe électrogène (9), à l'aide d'au moins un premier capteur (101) monté dans ledit dispositif (1) autonome ; et
- mesure d'un deuxième paramètre représentatif d'un état de fonctionnement dudit groupe électrogène (9), à l'aide d'au moins un deuxième capteur (102) monté dans ledit dispositif (1) autonome, lesdits premier et deuxième paramètres étant représentatifs d'aspects distincts du fonctionnement dudit groupe électrogène (9) ;
- traitement, délivrant ladite information caractéristique d'une durée de fonctionnement, en fonction desdits premier et deuxième paramètres, ledit groupe électrogène (9) étant considéré en fonctionnement lorsque les deux capteurs (101, 102) délivrent des paramètres indiquant un fonctionnement potentiel ;
- stockage interne de ladite information caractéristique d'une durée de fonctionnement ;
- transmission à un terminal ou un serveur externe de ladite information caractéristique d'une durée de fonctionnement.

## Patentansprüche

1. Autonome Vorrichtung (1) zur Überwachung der Betriebszeit eines Stromgenerators (9), die geeignet ist, mindestens eine Information bereitzustellen, die für eine Betriebsdauer des Stromgenerators (9) charakteristisch ist, wobei die Vorrichtung (1) aufweist:
- mindestens einen ersten Sensor (101), der geeignet ist, einen ersten Parameter zu messen, der für einen Betriebszustand des Stromgenerators (9) repräsentativ ist, und
- mindestens einen zweiten Sensor (102), der geeignet ist, einen zweiten Parameter zu messen, der für einen Betriebszustand des Stromgenerators (9) repräsentativ ist, wobei der erste und der zweite Parameter für verschiedene Aspekte des Betriebs des Stromgenerators (9) repräsentativ sind,
- Verarbeitungsmittel (104), die die Information, die für eine Betriebsdauer charakteristisch ist, in Abhängigkeit von dem ersten und dem zweiten Parameter bereitstellen, wobei der Stromgenerator (9) als in Betrieb betrachtet wird, wenn die zwei Sensoren (101, 102) Parameter bereitstellen, die einen potenziellen Betrieb anzeigen,
- Mittel (106) zum internen Speichern der Information, die für eine Betriebsdauer charakteristisch ist,
- Mittel (103) zum Übertragen, die geeignet sind, die Information, die für eine Betriebsdauer charakteristisch ist, an ein Endgerät oder an einen externen Server zu übertragen.

2. Autonome Vorrichtung (1) zur Überwachung der Betriebszeit nach Anspruch 1, **dadurch gekennzeichnet, dass** der erste und der zweite Sensor (101, 102) Sensoren ohne Kontakt mit dem Stromgenerator (9) sind.

3. Autonome Vorrichtung (1) zur Überwachung der Betriebszeit nach Anspruch 1, **dadurch gekennzeichnet, dass** der erste und der zweite Sensor (101, 102) sind:
- ein Magnetsensor (101), der geeignet ist, das Vorhandensein eines Magnetfelds zu erkennen, das von einem Wechselstromgenerator (92) des Stromgenerators (9) erzeugt wird, und
- ein Vibrationssensor (102), der geeignet ist, Vibrationen zu erfassen, die von einem Motor (91) des Stromgenerators (9) erzeugt werden.

4. Autonome Vorrichtung (1) zur Überwachung der Betriebszeit nach Anspruch 3, **dadurch gekennzeichnet, dass** der erste Sensor (101) ein Magnetsensor ist, der das Vorhandensein eines elektromagnetischen Feldes zwischen 25 und 450 µT erkennt.

5. Autonome Vorrichtung (1) zur Überwachung der Betriebszeit nach einem der Ansprüche 3 oder 4, **dadurch gekennzeichnet, dass** der zweite Sensor (102) ein Vibrationssensor ist, der Vibrationen zwischen 20 und 200 Hz erfasst.

6. Autonome Vorrichtung (1) zur Überwachung der Betriebszeit nach einem der Ansprüche 1 bis 5, **dadurch gekennzeichnet, dass** sie Mittel zur Geolokalisierung aufweist.

7. Autonome Vorrichtung (1) zur Überwachung der Betriebszeit nach einem der vorhergehenden Ansprüche, **dadurch gekennzeichnet, dass** die Mittel (103) zum Übertragen ein Bluetooth Low Energy Kommunikationsprotokoll implementieren.

8. Autonome Vorrichtung (1) zur Überwachung der Betriebszeit nach einem der vorhergehenden Ansprüche, **dadurch gekennzeichnet, dass** sie eindeutige Mittel (105) zum Identifizieren aufweist.

9. Stromgenerator (9), umfassend ein Gestell (90), auf dem insbesondere ein Motor (91) und ein Wechselstromgenerator (92) montiert sind, **dadurch gekennzeichnet, dass** er ferner eine autonome Vorrichtung (1) zur Überwachung der Betriebszeit nach einem der Ansprüche 1 bis 8 aufweist.

10. Stromgenerator (9) nach dem vorhergehenden Anspruch, **dadurch gekennzeichnet, dass** die autonome Vorrichtung (1) zur Überwachung der Betriebszeit durch mechanische Befestigungsmittel (13, 20, 21) an dem Gestell (90) befestigt ist.

11. Verfahren zur Überwachung der Betriebszeit eines Stromgenerators (9), das eine autonome Vorrichtung (1) nach einem der Ansprüche 1 bis 8 umsetzt, umfassend die folgenden Schritte:
- Messen eines ersten Parameters, der für einen Betriebszustand des Stromgenerators (9) repräsentativ ist, mit Hilfe von mindestens einem ersten Sensor (101), der auf der autonomen Vorrichtung (1) montiert ist, und
- Messen eines zweiten Parameters, der für einen Betriebszustand des Stromgenerators (9) repräsentativ ist, mit Hilfe von mindestens einem zweiten Sensor (102), der auf der autonomen Vorrichtung (1) montiert ist, wobei der erste und der zweite Parameter für verschiedene Aspekte des Betriebs des Stromgenerators (9) repräsentativ sind,
- Verarbeiten, wodurch die Information, die für eine Betriebsdauer charakteristisch ist, in Abhängigkeit von dem ersten und dem zweiten Parameter bereitgestellt wird, wobei der Stromgenerator (9) als in Betrieb betrachtet wird, wenn die zwei Sensoren (101, 102) Parameter bereitstellen, die einen potenziellen Betrieb anzeigen,
- internes Speichern der Information, die für eine Betriebsdauer charakteristisch ist,
- Übertragen der Information, die für eine Betriebsdauer charakteristisch ist, an ein Endgerät oder an einen externen Server.

## Claims

1. Standalone device (1) for monitoring time of use of a generator set (9), able to provide at least one piece of information characteristic of an operating time of said generator set (9), said device (1) comprising:
- at least one first sensor (101) able to measure a first parameter representative of an operating state of said generator set (9); and
- at least one second sensor (102) able to measure a second parameter representative of an operating state of said generator set (9), said first and second parameters being representative of distinct aspects of the operation of said generator set (9);
- processing means (104) delivering said characteristic piece of information of an operating time, as a function of said first and second parameters, said generator set (9) being considered as operating when both sensors (101, 102) deliver parameters indicating a potential operation;
- means (106) for internally storing said characteristic piece of information of an operating time;
- transmission means (103) able to transmit said characteristic piece of information of an operating time to a terminal or an external server.

2. Standalone device (1) for monitoring time of use according to claim 1, **characterised in that** said first and second sensors (101, 102) are sensors without contact with said generator set (9).

3. Standalone device (1) for monitoring time of use according to claim 1, **characterised in that** said first and second sensors (101, 102) are:
- a magnetic sensor (101) able to detect the presence of a magnetic field generated by an alternating current generator (92) of said generator set (9); and
- a vibration sensor (102) able to sense vibrations generated by an engine (91) of said generator set (9).

4. Standalone device (1) for monitoring time of use according to claim 3, **characterised in that** said first sensor (101) is a magnetic sensor detecting the presence of an electromagnetic field between 25 and 450 µT.

5. Standalone device (1) for monitoring time of use according to one of claims 3 or 4, **characterised in that** said second sensor (102) is a vibration sensor sensing vibrations between 20 and 200 Hz.

6. Standalone device (1) for monitoring time of use according to one of claims 1 to 5, **characterised in that** it comprises geolocation means.

7. Standalone device (1) for monitoring time of use according to one of the preceding claims, **characterised in that** the transmission means (103) implement a Bluetooth Low Energy communication protocol.

8. Standalone device (1) for monitoring time of use according to one of the preceding claims, **characterised in that** it comprises single identification means (105).

9. Generator set (9) comprising a chassis (90) to which an engine (91) and an alternating current generator (92) are mounted, **characterised in that** it further comprises a standalone device (1) for monitoring time of use according to one of claims 1 to 8.

10. Generator set (9) according to the preceding claim, **characterised in that** said standalone device (1) for monitoring time of use is attached to said chassis (90) through mechanical attachment means (13, 20, 21) .

11. Method for monitoring time of use of a generator set (9), implementing a standalone device (1) according to one of claims 1 to 8, comprising the following steps:
- measuring a first parameter representative of an operating state of said generator set (9), using at least one first sensor (101) mounted in said standalone device (1); and
- measuring a second parameter representative of an operating state of said generator set (9), using at least one second sensor (102) mounted in said standalone device (1), said first and second parameters being representative of distinct aspects of the operation of said generator set (9);
- processing, delivering said characteristic piece of information of an operating time, as a function of said first and second parameters, said generator set (9) being considered as operating when both sensors (101, 102) deliver parameters indicating a potential operation;
- internally storing said characteristic piece of information of an operating time;
- transmitting said characteristic piece of information of an operating time to a terminal or an external server.
